Europäisches Patentamt

European Patent Office

Office européen des brevets

(11) Veröffentlichungsnummer: **0 085 315**
**A2**

(12) **EUROPÄISCHE PATENTANMELDUNG**

(21) Anmeldenummer: 83100262.1

(22) Anmeldetag: 14.01.83

(51) Int. Cl.³: **H 01 R 13/66**
**H 01 R 23/68**

(30) Priorität: 29.01.82 DE 3203021

(43) Veröffentlichungstag der Anmeldung:
10.08.83 Patentblatt 83/32

(84) Benannte Vertragsstaaten:
CH DE FR GB LI NL

(71) Anmelder: HARTING ELEKTRONIK GmbH
Marienwerderstrasse 3 Postfach 1140
D-4992 Espelkamp(DE)

(72) Erfinder: Harting, Dietmar, Dipl.-Kaufmann
Schweriner Strasse 31
D-4992 Espelkamp(DE)

(72) Erfinder: Nagel, Hans, Dipl.-Ing.
Untkenbeeke 1
D-4952 Porta Westfalica(DE)

(72) Erfinder: Coors, Erich, Dipl.-Ing.
Schweriner Strasse 5
D-4992 Espelkamp(DE)

(54) Steckverbinder mit Entstöreinrichtung.

(57) Für einen Steckverbinder mit Entstöreinrichtung ist zur induktivitätsarmen Beschaltung der Steckverbinder-Kontakte vorgesehen, daß der Steckverbinder (1) mit einer Hilfs-Leiterplatte (4) versehen ist, die in dichter Anordnung zum Steckverbinder-Isolierkörper (12) angebracht ist. Die Entstörmittel (10) sind in Bohrungen (6) der Leiterplatte angeordnet und die eine Seite der Entstörmittel ist über kurze Leiterbahnen (7) mit dem jeweilig zugeordneten Anschlußpfosten (3) des Steckverbinders verbunden. Die andere Seite der Entstörmittel ist über eine gemeinsame, verbindende Leiterbahn (8) der Leiterplatte mit einem Masse-Anschluß bzw. dem metallischen Steckverbinder-Gehäuse (13) verbunden.

Fig. 2

Croydon Printing Company Ltd.

0085315

13. 1. 1983
1/82 - 09

## Steckverbinder mit Entstöreinrichtung

Die Erfindung betrifft einen Steckverbinder mit Entstöreinrichtung für Datenverarbeitungsanlagen bzw. Datenübertragungs-Schnittstellen.

Bei derartigen Steckverbindern an Schnitt- und Koppelstellen elektronischer Geräte ist es erforderlich, die
Steckverbinder-Anschlüsse, die die Datensignale führen,
wirksam abzuschirmen bzw. zur Gerätemasse hin abzublocken,
damit die die Datensignale führenden Leitungen keine Störsignale aussenden und somit benachbarte Geräte und Anlagen
beeinflussen. Dabei weisen diese Datensignale üblicherweise steile Anstiegs- und Abfallflanken auf, wodurch die
Entstehung von hochfrequenter Störstrahlung ungünstig gefördert wird.
Es ist bekannt zur Verhinderung der ungewollten Signalabstrahlung die Datenleitungen, sowie die Geräte selbst mit
Abschirmungen zu versehen. Es ist weiterhin bekannt als
Steckverbinder für die Schnittstellen zwischen elektronischen Geräten und Datenübertragungsleitungen spezielle
Steckverbinder mit sogenannten Filterkontakten
(L-C-Beschaltung) einzusetzen.

Es hat sich jedoch gezeigt, daß die Abschirmung der Datenleitungen und der Gerätegehäuse zur Verhinderung der Störabstrahlung allein nicht in allen Fällen ausreichend ist.
Der Einsatz von Steckverbindern mit Filterkontakten brachte
hier zwar Abhilfe, jedoch sind derartige Steckverbinder
äußerst aufwendig aufgebaut und damit unverhältnismäßig
kostspielig.

Eine Beschaltung der Datenleitungen auf der Ausgangs-
Leiterplatte des Datenübertragungsgerätes mit Entstörmitteln wie Abblock-Kondensatoren, die von den Datenleitungen zu einem geräteseitigen Massepunkt geführt
wurden bzw. ein paralleles Anlöten von Kondensatoren
von den Steckerstiften zu einem gemeinsamen Massepunkt
brachte zwar eine gewisse Verringerung der abgestrahlten
Störimpulse, jedoch war das Gesamtgergebnis aufgrund der
relativ langen Leitungsführung von den Steckerstiften zu
den Kondensatoren nicht zufriedenstellend bzw. aufgrund
der vielfältigen manuellen Manipulationen für eine industrielle Fertigung wenig geeignet.

Der Erfindung liegt die Aufgabe zugrunde, einen Steckverbinder zu schaffen, der mit Entstörmitteln wie Abblock-
Kondensatoren versehbar ist, wobei die Länge der Leitungsführung auf ein Minimum reduziert ist (induktivitätsarm)
und der industriell wirtschaftlich herstellbar ist.
Diese Aufgabe wird erfindungsgemäß dadurch gelöst, daß
der Steckverbinder an seiner, der Steckseite abgewandten
Seite mit den rückwärtigen Enden der Steckerstifte oder
Steckerbuchsen in eine Hilfs-Leiterplatte eingelötet ist,
daß in dieser Leiterplatte weiterhin Bohrungen nahe den
Steckerstift-Kontaktierungen vorgesehen sind, in die elektrische Bauelemente, vorzugsweise Vielschicht-Kondensatoren eingefügt sind, die auf der einen Seite der Leiterplatte mit je einer Leiterbahn die jeweils zu einem
Stecker-Anschlußpfosten geführt ist, kontaktiert (verlötet sind,
daß auf der gegenüberliegenden Seite der Leiterplatte
Leiterbahnen vorhanden sind, mit denen die andere Seite
der Bauelemente kontaktiert ist, und
daß diese Leiterbahnen zu einem gemeinsamen Masseanschluß
geführt sind.

Um einen derartigen, mit einer Hilfs-Leiterplatte versehenen Steckverbinder problemlos wie einen handelsüblichen Steckverbinder anwenden zu können, ist in einer weiteren Ausbildung des Steckverbinders vorgesehen, daß die rückwärtigen Enden der in die Leiterplatte eingelöteten Anschlußpfosten über die Leiterplatte hinausragen, so daß sie in eine weitere Haupt-Leiterplatte einlötbar sind, bzw. eine anderweitige weiterführende Verdrahtung wie Wrappen, Einzellötung etc. vorgenommen werden kann. Eine besonders vorteilhafte Ausbildung des erfindungsgemäßen Steckverbinders mit Entstöreinrichtung wird dadurch erzielt, daß die eingesetzten Bauelemente in ihrer Höhe in etwa der Dicke der verwendeten Leiterplatte entsprechen.

Eine äußerst wirksame Verminderung der abgestrahlten Störsignale erzielt man nach einer weiteren Ausbildung der Erfindung dadurch, daß der Steckverbinder-Isolierkörper mit einem metallischen Abschirmgehäuse versehen ist und daß der Masseanschluß der Leiterplatte mittels einer Lötbrücke hiermit verbunden ist.

In weiterer Ausgestaltung der Erfindung ist vorgesehen, daß die für die elektrische Zusammenfassung der einzelnen Bauelemente vorgesehene Seite der Leiterplatte mit einer ganzflächigen Kupfer-Kaschierung versehen ist, wobei an den Stellen, an denen die Anschluß-Pfosten des Steckverbinders zur gegenüberliegenden Seite der Leiterplatte hindurchgeführt sind, diese Kaschierung in einem gewissen Bereich (soweit, daß sich kein elektrischer Kontakt zwischen Kaschierung und Anschlußpfosten unter Beachtung der Kriechstrecken ergeben kann) entfernt ist.

Ein besonders vorteilhaftes Verfahren zur Herstellung des erfindungsgemäßen Steckverbinders ergibt sich bei Anwendung folgender Verfahrensschritte:

a) daß zunächst die Hilfs-Leiterplatte auf eine ebene Unterlage gelegt wird und die Bauelemente in die jeweiligen Bohrungen eingesetzt werden, so daß ihre Anschlußkappen zur Ober- bzw. Unterseite der Leiterplatte weisen, daß anschließend die Unterseite der Leiterplatte (Lötseite für die Anschlußpfosten 3) mit einem Klebeband abgedeckt wird,

b) daß die Oberseite der Leiterplatte in einem Lötbad mit den Bauelementen verlötet wird,

c) daß nach dem Entfernen des Klebebandes der Steckverbinder mit seinen Anschlußpfosten von der Oberseite der Leiterplatte her in die Bohrungen gesteckt und vollständig eingeschoben wird,

d) daß anschließend die Leiterbahnen mit den Pfosten und den Bauelementen in einem Lötbad verlötet werden, und

e) daß abschließend der gegebenenfalls erforderliche Masseanschluß mittels einer Lötbrücke zwischen der Leiterbahnfläche und dem metallischen Gehäuse erfolgt.

Die mit der Erfindung erzielten Vorteile betehen insbesondere darin, daß ein Steckverbinder mit Entstöreinrichtung durch Verwendung einer preisgünstigen Zusatz-Leiterplatte geschaffen wurde, der dadurch mit einer wirksamen Entstörung gegen Abstrahlung von Störsignalen versehen ist. Dabei ist durch Wahl und Anordnung der Entstörmittel (vorzugsweise keramische Vielschichtkondensatoren) dafür Sorge getragen, daß die Zusatz-Leiterplatte in ihren äußeren Abmessungen nicht über die äußere Kontur des Steckverbinder-Isolierkörpers hinausragt.

Weiterhin kann als Ausgangsteil für den erfindungsgemäßen Steckverbinder ein handelsüblicher Steckverbinder Anwendung finden, der nach dem Komplettieren mit der Zusatz-Leiterplatte in herkömmlicher Art und Weise eingebaut und weiterverarbeitet werden kann. Dabei ist es selbstverständlich und im Rahmen der Erfindung liegend, daß im Bedarfsfalle nicht sämtliche Steckverbinderkontakte, sondern nur einzelne, vorher ausgewählte, mit Entstörmitteln beschaltet sein müssen. Dies ist auf einfachste Art und Weise bei der Bestückung der Zusatz-Leiterplatte durch Fortlassen der Entstörmittel in den jeweiligen Bohrungen der Leiterplatte erzielbar.

Es ist weiterhin denkbar und wird als im Bereich der Erfindung liegend angesehen, daß die Leiterplatten-Oberseite, anstelle der Masse-Verbindungsbahnen, mit solchermaßen geführten Leiterbahnen versehen ist, daß die oberen Anschlüsse der Entstörmittel zu ausgewählten Kontaktpfosten führen, so daß die Entstörmittel elektrisch jeweils zwischen zwei Kontaktstifte geschaltet sind.

Ein Ausführungsbeispiel der Erfindung ist in der Zeichnung dargstellt und wird im folgenden näher erläutert.
Es zeigen

Fig. 1  die Ansicht eines Steckverbinders mit Hilfs-Leiterplatte,

Fig. 2  die Seitenansicht des Steckverbinders gemäß Fig.1 mit der Hilfs-Leiterplatte im Schnitt,

Fig. 3  die Unteransicht des Steckverbinders gemäß Fig. 1,

Fig. 4  die Ansicht einer Hilfs-Leiterplatte, und

Fig. 5  die Unteransicht der Leiterplatte gemäß Fig. 4.

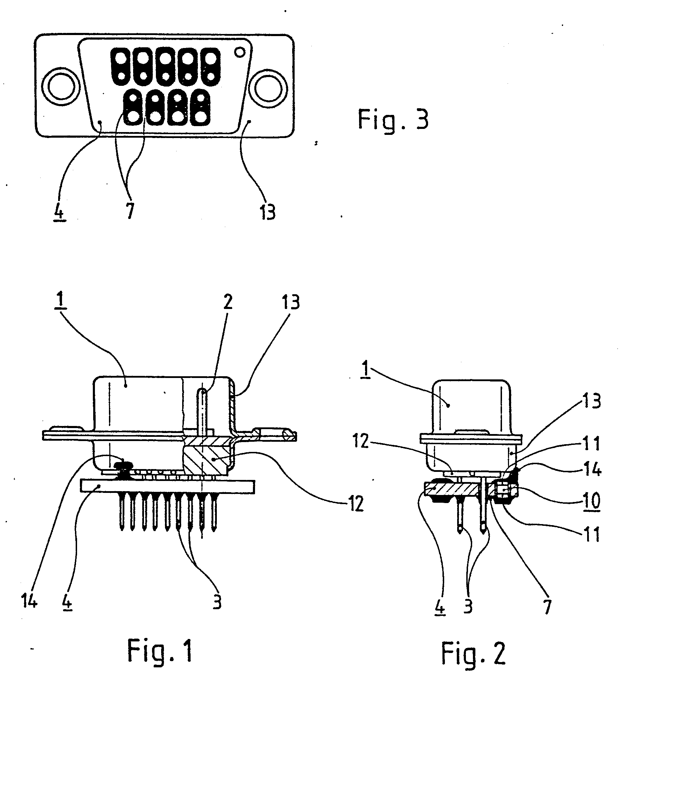

Der in den Fig.1 bis 3 dargestellte Steckverbinder besteht im wesentlichen aus einem handelsüblichen Steckverbinder 1 mit Stift- oder Buchsenkontakten 2, die auf der der Steckseite des Steckverbinders gegenüberliegenden Seite zu Einlöt- bzw. Wickel-Pfosten 3 verlängert sind,
sowie der Hilfs-Leiterplatte 4, die auf die Pfosten 3
aufgeschoben und hiermit verlötet ist.

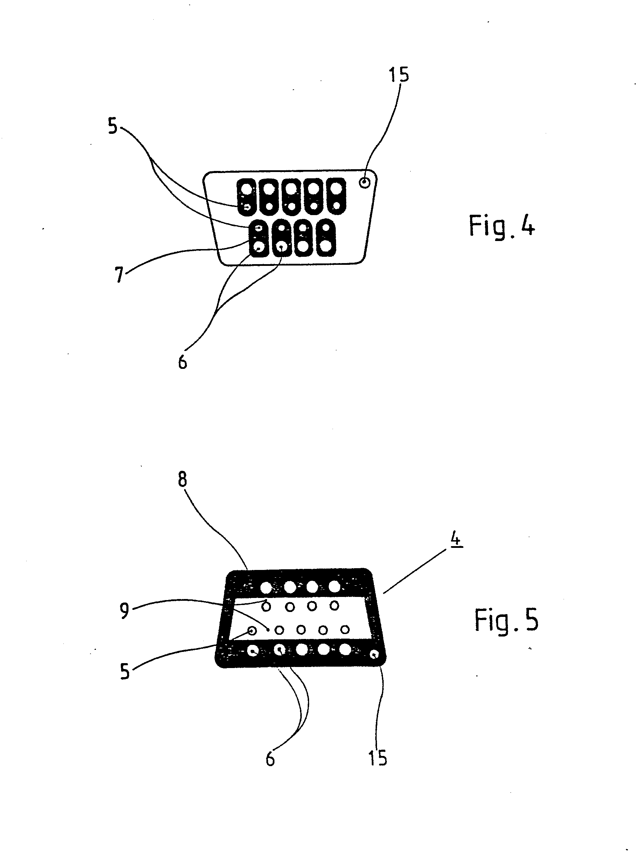

Die Leiterplatte 4, die in den Fig. 4 und 5 näher dargestellt ist, ist mit Durchgangs-Bohrung 5 entsprechend der
geometrischen Anordnung der Anschluß-Pfosten 3 des Steckverbinders 1 versehen.

Weiterhin weist die Leiterplatte die Bohrungen 6 auf, wobei den die Anschluß-Pfosten 3 aufnehmenden Bohrungen 5
jeweils eine Bohrung 6 möglichst dicht zugeordnet ist.
Diese dichte Zuordnung wurde gewählt, um die äußeren Abmessungen der Leiterplatte möglichst klein halten zu können und um die Leiterbahnen auf der Leiterplatte kurz, d.h.
induktivitätsarm gestalten zu können.

Die äußeren Abmessungen der Leiterplatte sind daher so gewählt, daß die Leiterplatte nicht über die äußere Kontur
des Steckverbinders 1 hinausragt. Die Leiterplatte 2 ist
auf einer Seite (vergl. Fig. 4) mit kurzen Leiterbahnen 7
versehen, die jeweils von einer Bohrung 5, die einen An-
schluß-Pfosten des Steckverbinders aufnimmt, zu der zugehörigen Bohrung 6 führen. Die andere Seite der Leiterplatte (vergl. Fig. 5) ist ebenfalls mit einer Leiterbahn 8 - durchgehende Kupfer-Kaschierung - versehen, die
alle Bohrungen 6 miteinander verbindet. Im Bereich 9 der
Durchgänge der Steckverbinder-Pfosten (Bohrungen 5) ist
diese Kaschierung jedoch mindestens soweit entfernt, daß
hier keine leitende Verbindung zwischen den durchgeführten
Steckverbinder-Pfosten und der/den Leiterbahnen 8 dieser
Leiterplatte entsteht. Dabei ist, abhängig vom jeweiligen
Anwendungsfall (Spannungsfestigkeit), der Abstand zwischen
Pfosten und Leiterbahn (Kupferkaschierung) so groß bemessen, daß die jeweils erforderlichen Kriechstrecken eingehalten werden.

In die Bohrungen 6 sind Kondensatoren 10 eingefügt, die endseitig Kontaktflächen bzw. Kontaktkappen 11 aufweisen. Hierbei handelt es sich vorzugsweise um keramische Vielschicht-Kondensatoren, die in ihrer Höhe in etwa der Dicke der verwendeten Leiterplatte 2 entsprechen um ein annähernd bündiges Einsetzen der Kondensatoren in die Bohrungen zu ermöglichen. Die Kondensatoren-Anschlüsse 11 sind auf beiden Seiten der Leiterplatte mit den an die Bohrungsränder heranreichenden Leiterbahnen 7, 8 verlötet.

Wie in Fig.1 und 2 dargestellt, ist die Leiterplatte auf die Anschlußpfosten des Steckverbinders aufgeschoben, so daß die in Fig. 4 dargestellte Seite der Leiterplatte nach unten weist und die Anschluß-Pfosten 3 sind mit den Leiterbahnen 7 der Leiterplatte verlötet.
Im Ausführungsbeispiel besteht der Steckverbinder 1 aus einem, die Stift- oder Buchsenkontakte aufnehmenden Isolierkörper 12 der mit einem metallischen Abschirm- und Befestigungs-Kragen 13 versehen ist. Die Oberseite der Leiterplatte, d.h. die Seite auf der die Kondensatoren über die Leiterbahn 8 elektrisch miteinander verbunden sind, ist an mindestens einer Stelle mittels der Lötbrücke 14 zwischen Leiterbahn und metallischem Kragen verbunden.

Für Steckverbinder, die keinen metallischen Kragen bzw. metallisches Gehäuse aufweisen, kann vorgesehen sein, daß die Oberseite der Leiterplatte (Leiterbahn 8) über einen separaten Anschluß 15 an Massepotential gelegt wird, oder daß ein ausgewählter Anschlußpfosten des Steckverbinders selbst Massepotential führt und daß die Leiterbahn 8 der Oberseite der Leiterplatte zu diesem Pfosten geführt und hiermit verlötet ist.

13.1. 1983
1/82 - 09

Patentansprüche
================

1. Steckverbinder mit Entstöreinrichtung für Datenverarbeitungsanlagen bzw. Datenübertragungs-Schnittstellen, dadurch gekennzeichnet,

daß der Steckverbinder (1) an seiner, der Steckseite abgewandten Seite mit den rückwärtigen Enden (3) der Steckerstifte oder Steckerbuchsen (2) in eine Hilfs-Leiterplatte (4) eingelötet ist,

daß in dieser Leiterplatte weiterhin Bohrungen (6) nahe den Steckerstift-Kontaktierungen vorgesehen sind, in die elektrische Bauelemente (10), vorzugsweise Vielschicht-Kondensatoren eingefügt sind, die auf der einen Seite der Leiterplatte mit je einer Leiterbahn (7), die jeweils zu einem Stecker-Anschlußpfosten (3) geführt ist, kontaktiert (verlötet) sind,

daß auf der gegenüberliegenden Seite der Leiterplatte Leiterbahnen (8) vorhanden sind, mit denen die andere Seite der Bauelemente (10) kontaktiert ist, und

daß diese Leiterbahnen (8) zu einem gemeinsamen Masseanschluß (14, 15) geführt sind.

2. Steckverbinder nach Anschluß 1, dadurch gekennzeichnet, daß die rückwärtigen Enden (3) der in die Leiterplatte (4) eingelöteten Anschlußpfosten über die Leiterplatte hinausragen, so daß sie in eine weitere Haupt-Leiterplatte einlötbar sind, bzw. eine anderweitige weiterführende Verdrahtung wie Wrappen, Einzellötung etc. vorgenommen werden kann.

3. Steckverbinder nach Anspruch 1 oder 2, dadurch
   gekennzeichnet,
   daß die Bauelemente (10) in ihrer Höhe in etwa der
   Dicke der verwendeten Leiterplatte (4) entsprechen.

4. Steckverbinder nach Anspruch 1 oder folgenden,
   dadurch gekennzeichnet,
   daß der Steckverbinder Isolierkörper (12) mit einem
   metallischen Abschirmgehäuse (13) versehen ist und
   daß der Masseanschluß (8, 15) der Leiterplatte (4)
   mittels einer Lötbrücke (14) hiermit verbunden ist.

5. Steckverbinder nach Anspruch 1 oder folgenden, dadurch gekennzeichnet,
   daß die für die elektrische Zusammenfassung der einzelnen Bauelemente (10) vorgesehene Seite der Leiterplatte (4) mit einer ganzflächigen Kupfer-Kaschierung
   versehen ist, wobei an den Stellen, an denen die Anschluß-Pfosten (3) des Steckverbinders (1) zur gegenüberliegenden Seite der Leiterplatte hindurchgeführt
   sind, diese Kaschierung in einem gewissen Bereich (9)
   entfernt ist.

6. Verfahren zur Herstellung eines Steckverbinders mit
   Entstöreinrichtung, dadurch gekennzeichnet,
   daß zunächst die Hilfs-Leiterplatte (4) auf eine ebene
   Unterlage gelegt wird und die Bauelemente (10) in die
   jeweiligen Bohrungen (6) eingesetzt werden, so daß
   ihre Anschlußkappen (11) zur Ober- bzw. Unterseite der
   Leiterplatte weisen,
   daß anschließend die Unterseite der Leiterplatte
   (Lötseite für die Anschlußpfosten 3) mit einem Klebeband abgedeckt wird,
   daß nach dem Entfernen des Klebebandes der Steckverbinder (1) mit seinem Anschluß-Pfosten (3) von der
   Oberseite der Leiterplatte her in die Bohrungen (5) gesteckt und vollständig eingeschoben wird,

daß anschließend die Leiterbahnen (7) mit den Pfosten (3) und den Bauelementen (10) in einem Lötbad verlötet werden, und

daß abschließend der gegebenenfalls erforderliche Masseanschluß mittels einer Lötbrücke (14) zwischen der Leiterbahnfläche (8) und dem metallischen Gehäuse (13) erfolgt.

Fig. 3

4    7    13

1    2    13

12

14    4    3

Fig. 1

1

12    13
11
14
10
11

4    3    7

Fig. 2

Fig.4

Fig.5